(19)

**Europäisches Patentamt**

**European Patent Office**

**Office européen des brevets**

(11) **EP 3 229 030 A1**

(12) **EUROPEAN PATENT APPLICATION**

(43) Date of publication:
**11.10.2017 Bulletin 2017/41**

(51) Int Cl.:
**G01R 13/00** (2006.01)   **G01R 13/22** (2006.01)
**H03H 21/00** (2006.01)   **H03M 1/12** (2006.01)

(21) Application number: **17165599.6**

(22) Date of filing: **07.04.2017**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **08.04.2016 US 201662319916 P
31.03.2017 US 201715476676**

(71) Applicant: **Tektronix, Inc.
Beaverton, Oregon 97077-0001 (US)**

(72) Inventors:
• **PICKERD, John J
Hillsboro, Oregon 97123 (US)**
• **TAN, Kan
Portland, Oregon 97229 (US)**

(74) Representative: **HGF Limited
Fountain Precinct
Balm Green
Sheffield S1 2JA (GB)**

(54) **LINEAR NOISE REDUCTION FOR A TEST AND MEASUREMENT SYSTEM**

(57)    Disclosed is a mechanism for reducing noise caused by an analog to digital conversion in a test and measurement system. An adaptive linear filter is generated based on a converted digital signal and measured signal noise. The adaptive linear filter includes a randomness suppression factor for alleviating statistical errors caused by a comparison of a signal circularity coefficient and a noise circularity coefficient in the adaptive linear filter. The adaptive linear filter is applied to the digital signal along with a stomp filter and a suppression clamp filter. The digital signal may be displayed in a complex frequency domain along with depictions of the adaptive linear filter frequency response and corresponding circularity coefficients. The display may be animated to allow a user to view the signal and/or filters in the frequency domain at different times.

FIG. 1

**Description**

CROSS-REFERENCES TO RELATED APPLICATIONS

The present application claims benefit from U.S. Provisional Patent Application Ser. No. 62/319,916, filed April 8, 2016 by John J. Pickerd et al., and entitled "Widely Linear Noise Reduction And Analysis System For A Test And Measurement Instrument," which is incorporated herein by reference as if reproduced in its entirety.

FIELD OF THE INVENTION

This disclosure is directed to systems and methods associated with aspects of a test and measurement system, and, more particularly, to systems and methods for employing filters to reduce signal noise in the test and measurement system.

BACKGROUND

Test and measurement systems are designed to receive signal inputs, e.g. from a Device Under Test (DUT), sample the signals, and display the result as a waveform. The signal inputs may be received via a link, e.g. a signal connection, a communication(s) link, input port or the like. The signal inputs may be received as analog signals. The analog signals may then be converted into digital signals via a digitizer. The digital signals may be further analyzed for display. However, digital conversion may add noise to the digital signal, which may result in a less accurate signal displayed to the user.
Examples in the disclosure address these and other issues.

BRIEF DESCRIPTION OF THE DRAWINGS

The patent or application file contains at least one drawing executed in color. Copies of this patent or patent application publication with color drawing(s) will be provided by the Office upon request and payment of the necessary fee.
Aspects, features and advantages of embodiments of the present disclosure will become apparent from the following description of embodiments in reference to the appended drawings in which:

Fig. 1 is a block diagram of an example test and measurement system including an oscilloscope configured to apply an adaptive linear filter to a waveform to reduce analog to digital conversion noise.
Fig. 2 is a block diagram of an example test and measurement system for displaying results from an adaptive linear filter.
Fig. 3 illustrates an example application control menu system for controlling an adaptive linear filter.
Fig. 4 is a flow chart of an example method to apply an adaptive linear filter to a converted digital signal.
Figs. 5A-5B are a flow chart of an example method of generating an adaptive linear filter.
Fig. 6 illustrates an example mechanism for converting an input signal into a complex frequency domain signal.
Fig. 7 illustrates an example plot of an unfiltered frequency domain signal along with corresponding filters.
Fig. 8 illustrates an example plot of a signal before and after noise reduction by an adaptive linear filter.
Fig. 9 illustrates an example complex distribution animation.
Fig. 10 illustrates an example plot of circularity coefficients plotted as a function of frequency.
Fig. 11 illustrates an example plot of circularity coefficients plotted for an fast Fourier transform (FFT) frame on a real and imaginary axis.
Fig. 12 illustrates an example plot of variance coefficients plotted as a function of frequency.

DETAILED DESCRIPTION

Disclosed herein is a mechanism for generating an adaptive linear filter for application to a digital signal to reduce noise introduced during conversion from an analog signal. An analog signal is received at a test and measurement system and converted into a digital signal by an analog to digital (A/D) converter. The digital signal is converted into a complex frequency domain by employing a transform, such as a fast Fourier transform (FFT) and/or a short time FFT (STFT). The signal noise may result in certain statistical anomalies when converted in the complex frequency domain. An adaptive linear filter addresses statistical anomalies related to both signal/noise covariance and signal/noise pseudo covariance. Specifically, the adaptive linear filter provides significant noise reduction when the noise has a circular distribution in the complex frequency domain while the signal has a non-circular distribution. The adaptive linear filter is determined by computing a variance for the signal and the noise. The variance is employed to determine circularity coefficients for the signal and the noise. The circularity coefficients are in turn employed to determine adaptive linear coefficients. The adaptive linear coefficients are then employed to determine the proper values for the adaptive linear filters. A randomness suppression factor is employed in determining the adaptive linear coefficients. The randomness suppression factor is employed in an effort to alleviate statistical errors caused by the comparison of the signal circularity coefficient and the noise circularity coefficient. A suppression clamp is also applied to results from the adaptive linear filter. The suppression clamp may alleviate sampling errors at a Nyquist frequency of the A/D converter. Further, a bandwidth stomp filter may be employed to remove noise from the digital signal above a specified frequency. The adaptive linear filter and the bandwidth stomp filter may be plotted along with the digital signal in the complex frequency domain to inform a user as to the effects of the filters. A complex distribution display may also be employed to depict a spectrum of the signal/noise along a real and an imaginary axis in the complex frequency domain. Further, circularity coefficients and variance coefficients may also be displayed. Such plots or graphs may be animated to allow a user to view various frequency domain statistics of a signal at various points in time.

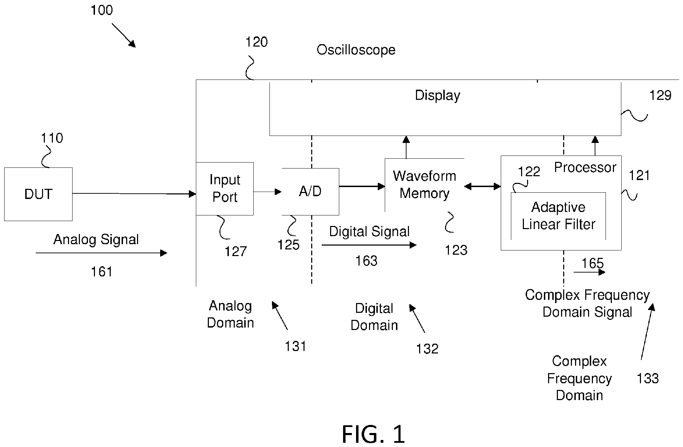

Fig. 1 is a block diagram of an example test and measurement system 100 including an oscilloscope 120 configured to apply an adaptive linear filter 122 to a waveform to reduce analog to digital conversion noise. The oscilloscope 120 is configured to receive an analog signal 161 from a device under test (DUT) 110, employ an A/D converter 125 to convert the signal into a digital signal 163, and apply an adaptive linear filter 122 to reduce noise introduced by the A/D converter 125.

The DUT 110 may be any signal source configured to communicate via electrical signals. For example, DUT 110 may include a transmitter (Tx) configured to transmit signals over an electrically conductive medium. The DUT 110 may be coupled to the oscilloscope 120 for testing purposes, for example when the DUT 110 is believed to be engaged in transmitting faulty signals and/or for verification of signaling accuracy for a newly designed DUT 110. In some cases, the analog signal 161 may be contained within the DUT 110, and may be accessed by utilizing a signal probe. The DUT 110 may be connected to the oscilloscope 120 via a DUT link. For example, the DUT link 113 may employ electrically conductive wire, signal probes, intervening test equipment, etc. to get the signal from the DUT 110 to the oscilloscope 120.

The analog signal 161 is received at the oscilloscope 120 at an input port 127. The input port 127 can be any electrical component configured to interface with a DUT 110 via a link, such as, for example, a plug for receiving a signal probe. The analog signal 161 is any continuous signal with a quantity (e.g. voltage, current, etc.) that varies relative to time. The oscilloscope 120 further includes a signal channel to conduct signals for testing. The signal channel can extend from the input port 127 to sampling circuitry of the oscilloscope 120. The oscilloscope 120 also includes an A/D converter 125 along the signal channel. The A/D converter 125 is configured to convert the analog signal 161 (e.g. input signal) from an analog format into a digital format (e.g. into a digital signal). Specifically, the input signal is treated by the oscilloscope 120 as an analog signal 161 until reaching the A/D converter 125 and then treated as a digital signal 163 after conversion. For clarity of discussion, components that interact with the analog signal 161 are referred to herein as acting in the analog domain 131 while components that interact with the digital signal 163 are referred to herein as acting in the digital domain 132. The boundary between the analog domain 131 and digital domain 132 is depicted as a dashed line bisecting the A/D converter 125 as the A/D converter 125 interacts with the signal in both domains. Accordingly, the A/D converter 125 is configured to convert the analog signal 161 from the analog domain 131 into a digital signal 163 in the digital domain 132. The A/D converter 125 may convert the analog signal 161 into the digital signal 163 by sampling the analog signal 161 at discrete points in time, which results in a discrete noncontinuous signal. A representation of the analog signal 161 can then be reproduced by interpolating between the discreet points in time. The process of digitizing the signal may result in noise added to the digital signal 163 that may not have been present in the analog signal 161. Because of this noise, the digital signal 163 may not be a sufficiently accurate representation of the analog signal 161.

The digital signal 163 may be stored in waveform memory 123 for further processing. Waveform memory 123 may be any memory configured to store and retrieve waveform samples. The waveform memory 123 may be coupled to the A/D converter 125, and may store the digital signal 163. The waveform memory 123 may be implemented in cache memory, random access memory (RAM), read only memory (ROM), solid state drives, etc. The waveform memory 123 may forward the digital signal 163 to a processor 121 for further processing upon request. The waveform memory 123 may store the digital signal 163 in the time domain and/or the complex frequency domain signal 165 after conversion by the processor 121 as discussed below. For example, the waveform memory 123 may store spectrums of the complex frequency domain signal 165 in a first in first out (FIFO) memory during processing to reduce the amount of computation performed by processor 121. As another example, the spectrums of a frequency domain signal Y may be stored in anNxM matrix (e.g. a FIFO matrix) indexed at various time positions N and by various time frame lengths M. This arrangement allows only M/2 FFTs to be computed each time a filter moves down the record, indexed by steps of k.

The processor 121 is any processing circuit configured to condition a digital signal 163 for display and/or convert the signal 163 into a desired format. The processor 121 may be implemented via one or more circuits, such as noise filters, interpolators, conversion circuits, etc. The processor 121 may be implemented in a digital signal processor (DSP), a general purpose processor, a field programmable gate array (FPGA), application specific integrated circuit (ASIC), and/or combinations thereof. The processor 121 may be employed to apply an adaptive linear filter 122 to the digital signal 163 in order to reduce signal noise created by the A/D converter 125. The processor 121 may be configured to convert the digital signal 163 into a complex frequency domain signal 165 in the complex frequency domain 133. A complex frequency domain signal 165 may be any signal converted to depict signal frequency and/or signal phase over successive periods of time. For example, a complex frequency domain signal 165 may be obtained by applying a transform, such as an FFT and/or a STFT, to the digital signal 163. For clarity of discussion, components that interact with the analog signal 161 are referred to herein as acting in the analog domain 131 while components that interact with the complex frequency domain signal 165 are referred to herein as acting in the complex frequency domain 133. The boundary between the digital domain 132 and the complex frequency domain 133 is depicted as a dashed line bisecting the processor 121 as the processor 121 interacts with the signal in both domains. Accordingly, the processor 121 is configured to convert the digital signal 163 in the digital domain 132 into a complex frequency domain signal 165 in the complex frequency domain 133. The processor 121 may store the complex frequency domain signal 165 back in the waveform memory 123 or forward the results to the display 129.

Once in the complex frequency domain 133, the noise can be removed from the signal by employing various filters. For example, an adaptive linear filter 122 may be employed to reduce/remove noise created by the A/D converter 125. Specifically, employing a transform may involve the use of various statistical mechanisms. Such mechanisms generate certain statistical anomalies related to the noise from the A/D converter 125 when the digital signal is converted to the complex frequency domain 133. The adaptive linear filter 122 addresses statistical anomalies related to both signal/noise covariance and signal/noise pseudo covariance. Specifically, the adaptive linear filter 122 provides significant noise reduction when the noise has a circular distribution in the complex frequency domain 133 while the complex frequency domain signal 165 has a non-circular distribution. The adaptive linear filter 122 is determined based on the signal to which the filter is applied, as discussed further below. An adaptive filter 122 is any filter based on a linear combination of inputs that varies in time based on a reference, such as a signal error.

The adaptive linear filter 122 may be determined, in part, by computing and comparing a signal circularity coefficient for the complex frequency domain signal 165 (e.g. analog signal 161 plus A/D converter 125 noise) and a noise circularity coefficient for the A/D converter 125 noise (e.g. noise created by the A/D converter 125 with no input signal). The circularity coefficients are computed by employing certain statistical mechanisms, as discussed in more detail below. Such statistical mechanisms may result in errors in certain circumstances, for example divide by zero errors or large results when the circularity coefficients are near zero. The adaptive line filter 122 may include a randomness suppression factor to help alleviate such statistical errors.

Further, half the sampling rate of a sampler, such as A/D converter 125, may be referred to as the sampler's Nyquist frequency. Certain sampling errors around the Nyquist frequency may cause amplitude errors to appear once the digital signal 163 is converted into a complex frequency domain signal 165. Accordingly, the processor 121 may apply a suppression clamp to the results from the adaptive linear filter 122. The suppression clamp may alleviate the results of the sampling errors at the Nyquist frequency of the A/D converter 125. Further, the processor 121 may apply a bandwidth stomp filter to the complex frequency domain signal 165 to remove channel noise from the signal above a specified frequency.

After processing, the complex frequency domain signal 165, the digital signal 163, and/or any related filters and/or intermediate calculations may be forwarded from the processor 121 to the display 129 for presentation to a user. A display 129 is any device configured to output information in visual form. For example, the display 129 may include a digital display, a cathode ray tube, a light emitting diode (LED) display, a plasma screen display, etc. The display 129 may contain one or more graticules for displaying waveforms. The display 129 may be included in the oscilloscope 120, or may be a separate display (e.g. a monitor) that receives data from the oscilloscope 120 via a general purpose computer. The display 129 may display a wide variety of data, including the digital signal 163, the complex frequency domain signal 165, and/or intermediate data. Hence the display 129 is depicted as part of the analog domain 131, the digital domain 132, and the complex frequency domain 133.

It should be noted that oscilloscope 120 may also include other components to capture and display waveforms of signals, as is understood by a person of ordinary skill in the art. It will be appreciated that such components are not shown in the interest of clarity.

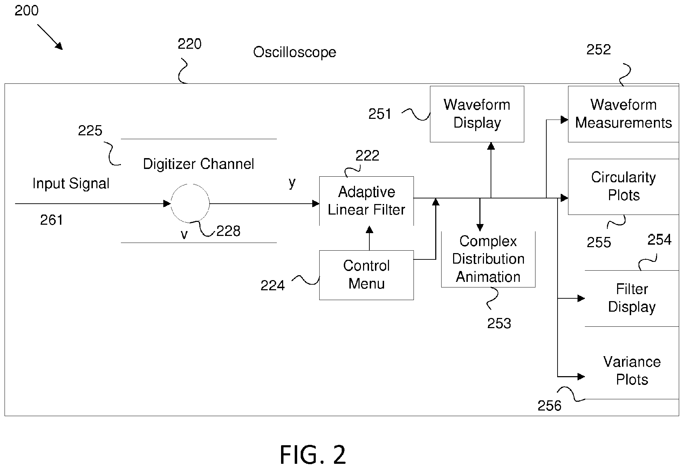

Fig. 2 is a block diagram of an example test and measurement system 200 for displaying results from an adaptive linear filter 222. System 200 depicts an example of system 100 in terms of functional components. System 200 includes an oscilloscope 220, which may be substantially similar to oscilloscope 120. Oscilloscope 220 may receive an input signal 261, which may be substantially similar to analog signal 161. The input signal 261 is received at a digitizer channel 225. The digitizer channel 225 is any group of components configured to convert a signal from an analog format into a digital format. For example, the digitizer channel 225 may include an A/D converter, such as A/D converter 125. As noted above, the process of sampling to convert an analog input signal, such as input signal 261, into a digital format may add some undesired noise 228 into the input signal. Added signal noise may be denoted herein as v, while a digital signal combined with the signal noise may be denoted as y.

The digital signal may be stored in a waveform memory and forwarded to a processor implementing an adaptive linear filter 222, which may be substantially similar to adaptive filter 122. For example, the processor may apply the adaptive linear filter 222 to remove/reduce the signal noise applied by applying a time-frequency transform to convert the digital signal into a complex frequency domain. The processor then determines a signal circularity coefficient for the digital signal y and a noise circularity coefficient for the signal noise v. The processor then generates frequency domain coefficients for the adaptive linear filter by comparing the signal circularity coefficient and the noise circularity coefficient. In some instances statistical errors can be alleviated by including a randomness suppression factor when generating the frequency domain coefficients. The processor may then apply the adaptive linear filter to the digital signal y. The adaptive linear filter 222 (and/or 122) and the corresponding processor(s) maybe employed to implement method 400, 500, and/or any other method, or portion thereof, disclosed herein.

The output from the adaptive linear filter 222 may be forwarded to a display, such as display 129, as a waveform display 251, waveform measurements 252, circularity plots 255, a filter display 254, a complex distribution animation 253, and/or variance plots 256. The waveform display 251 is a display format that displays a waveform based on the values of the input signal 261. For example, the waveform display 251 may display a waveform indicating the values of input signal 261, as filtered for noise, in the frequency domain. As another example, the filtered waveform may be converted back into the time domain by applying an inverse FFT (IFFT) and displayed in the waveform display 251. As another example, the waveform display 251 can display the filtered waveform in the form of time vs frequency magnitude as a spectrogram plot.

Waveform measurements 252 is a display function that depicts measured characteristics of the input signal 261 as defined by a user. Such waveform measurements 252 are depicted after noise is removed by the adaptive linear filter 222.

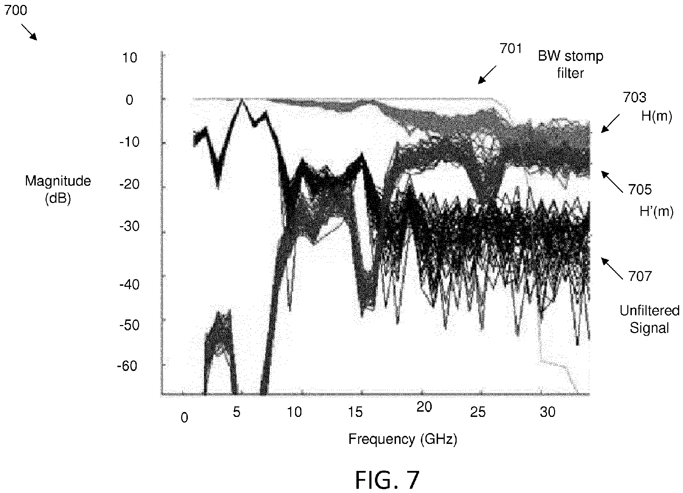

Filter display 254 is a display function that plots the effects of the adaptive linear filter, stomp filter, and/or any other filters, on the digital signal. Fig 7 depicts an example filter display 254. For example, the filters may be overlayed onto a plot of the unfiltered signal y. Filter display 254 may allow application of the filters to be monitored, for example at any position along the waveform. The filter display 254 may be animated and show different time positions in different frames. The filter display 254 may also depict an accumulated persistence of all frames in the record (e.g. saved in waveform memory) overlayed on a single display frame.

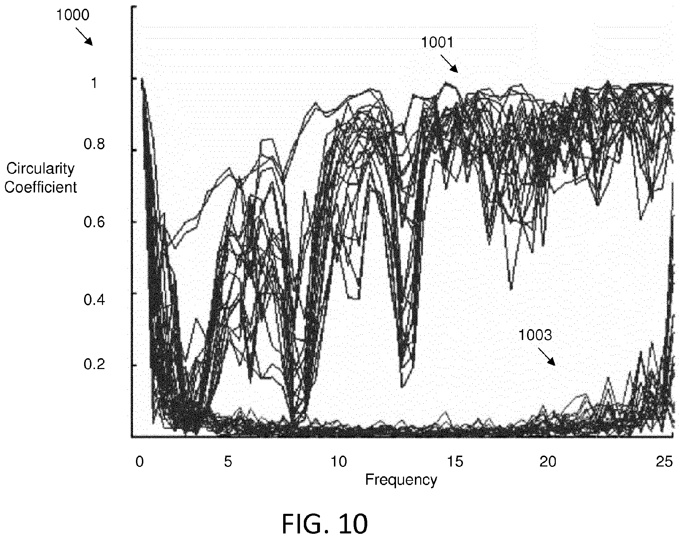

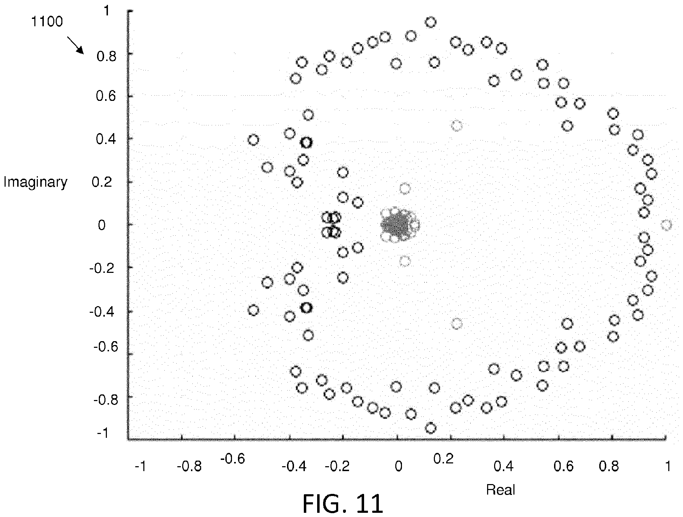

Circularity plots 255 is a display function that plots circularity coefficients for the digital signal, the noise, and/or the unfiltered signal y. The circularity coefficients may be calculated when determining the adaptive linear filter 222 as discussed in detail below. The adaptive linear filter 222 may be particularly effective when the signal is non-circular and the noise is circular. Accordingly, the circularity plots 255 may allow a user to evaluate the effectiveness of the adaptive linear filter 222 when applied to a digital. The circularity plots 255 may be displayed using persistence and/or animated to show different time periods in different frames, an example of which is shown in Figs 10 and 11, respectively.

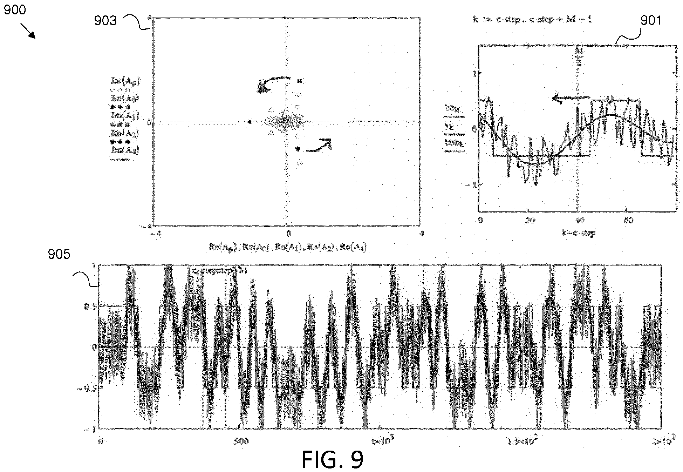

Complex distribution animation 253 is a display function that plots a spectrum from each frame of the STFT for each frame of video. The spectrum may be displayed on the real and imaginary axis. Therefore, the display shows the distribution of signal and noise power as a function of phase and magnitude on a single two dimensional plot. The plot may be animated as a function of delay along the unfiltered signal y. The plot may be useful for observing the circularity or non-circularity characteristics of the signal and noise at localized time positions. The plot may also be useful for observing signal abnormalities. The plot may allow an observer to distinguish the coherent components of the signal with respect to the noise distribution. The plot may allow such components to be distinguishable even when such signal components are positioned within the noise distribution. An example complex distribution animation 253 is depicted in Fig. 9. The animation may allow a user to view the spectral distribution of the signal and noise at various time points/temporal locations.

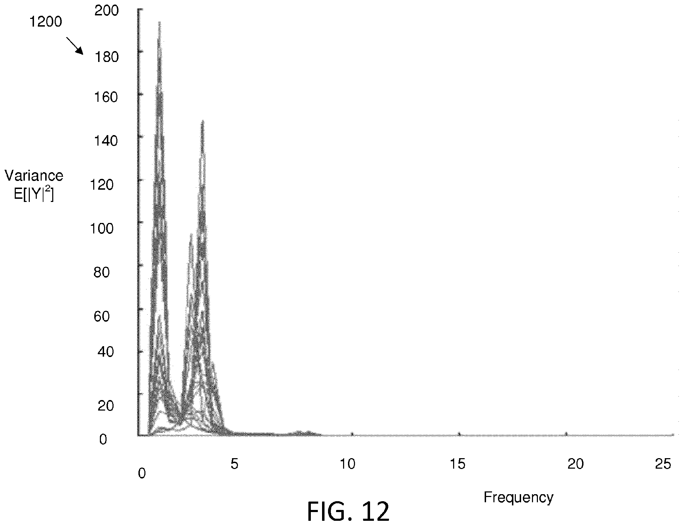

Variance plots 256 is a display function that plots the variance of the unfiltered signal y in the frequency domain and/or the variance of the signal noise 228 v. The variance of the noise and the signal may be calculated according to block 509 of method 500 as discussed below. The variance plots 256 provide additional data for the user, as variance of the signal and noise are employed to calculate circularity coefficients for the signal and the noise, respectively, and further have an impact on the determination of the values for the adaptive linear filter 222. An example variance plot, as generated by variance plots 256 is shown in Fig. 12 as discussed below.

The control menu 224 may include any controls that may be employed by a user to control sampling, filtering, and/or display of the input signal 261, and/or the digital signal based on input signal 261. The control menu 224 may accept user input to select the filter(s) applied to the digital signal as well as the form of the waveform displayed, for example by a display 129. The control menu 224 may be implemented as knobs, buttons, mouse input, keyboard input, etc. In some embodiments, the control menu 224 may be implemented as a graphical user interface that accepts commands via a touchscreen and provides feedback via the touchscreen.

By employing the functionality of oscilloscopes 120, 220, and/or combinations thereof, a non-circular signal with highly circular noise, for example as caused by an A/D converter in a digital channel, can be filtered. Noise reduction from such filtration can be achieved on the order of about three decibels without distorting the signal. Including the bandwidth stomp filter may further increase signal to noise ratio (SNR) on the order of about five to six decibles in some instances. Further, by displaying the effects of filters, such as the adaptive linear filter 122/222 and bandwidth stomp filter in filter display 254, displaying intermediate computational components such as signal and noise circularity coefficients in circularity plots 255 and/or signal and noise variance in variance plots 256, and/or animating frequency spectrums of the filtered signal over various time frames in by complex distribution animation 253, the user can be provided with greater control and feedback in the processes employed to condition the signal. For example, the user may employ the visualizations to determine whether the filters provide sufficient noise reduction on a particular signal to justify associated computational overhead. The visualizations may also be employed to select filter variables such as frame length, stomp filter coefficients, etc. As such, employing the functions disclosed herein can provide greater functionality in oscilloscope 120 and/or 220 provide a more accurate output waveform displayed to the user.

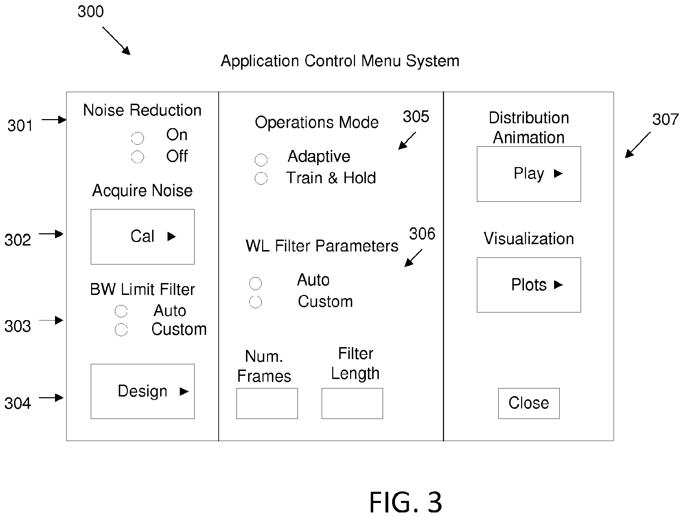

Fig. 3 illustrates an example application control menu system 300 for controlling an adaptive linear filter, such as adaptive linear filter 122/222, and displaying results. For example, menu system 300 may be employed as a control menu 224 for use in conjunction with a display, such as a display 129. Menu system 300 includes a noise reduction setting 301. The noise reduction setting 301 receives input from the user and turns the adaptive linear filter on and off. The noise reduction setting 301 may be turned off for cases where noise reduction provides no useful benefits, such as when the input signal is highly circular, for example when the input signal is white noise. The noise reduction setting 301 may also be turned off when the SNR of the signal is high and the user does not desire the extra noise reduction.

The menu system 300 further includes an acquire noise calibration setting 302. The acquire noise calibration setting 302 is employed to determine baseline noise in the oscilloscope, for example noise caused by an A/D converter. When a user first presses the acquire noise calibration setting 302 an additional menu or auto-calibration system may be displayed to ask the user to set the oscilloscope to the desired settings for acquiring a signal. The user may then be directed to remove the signal from the input channel. The system may then acquire the baseline noise of the test instrument and process the noise to measure the variance and the circularity coefficients. The variance and the circularity coefficients of the system noise may be saved and used later when computing the filter coefficients. The user is then directed to connect the input signal back into the input channel.

The menu system 300 further includes a bandwidth (BW) stomp filter setting 303. The BW stomp filter setting 303 provides the user with a choice of letting the system determine the bandwidth limit for the BW stomp filter, or selecting the bandwidth setting manually. The plots from the overlay of magnitude vs frequency may aid the user in determining where the BW stomp filter should be set. The plots from the overlay of magnitude vs frequency may also be employed to automatically determine the bandwidth limit for the BW stomp filter.

The menu system 300 further includes a design BW filter button 304. The design BW filter button 304 displays a filter design menu that allows the user to choose parameters for the cutoff frequency of the filter. Other parameters may also be displayed to the user via the filter design menu.

The menu system 300 further includes an operations mode setting 305. The operations mode setting 305 may provide for selection of an auto mode or a train and hold mode. When the auto mode is selected, a pair of adaptive linear coefficients and/or an adaptive linear filter is computed for each k position along the waveform record. When the train and hold mode is selected, the adaptive linear filter is computed from an average of k positions during a training computation. Then the single pair of adaptive linear coefficients are applied to the entire waveform record for each k position frame, as discussed more fully below.

The menu system 300 further includes a widely linear (WL) filter parameters setting 306. The WL filter parameters setting 306 accepts user input to configure the adaptive linear filter (e.g. also referred to as a widely linear filter). The WL filter parameters setting 306 allows the user to configure the FFT length, which may be equal to the filter length, as indexed by M. The WL filter parameters setting 306 also allows the user to configure the number of frames along the time record used for one filter computation, as indexed by N. When auto is selected, the system selects the values for N and for M. When custom is selected, an edit box is displayed allowing the user to set the N and M parameters. This allows the user to choose values based on tradeoffs of localization and performance, as determined by the various plots that are displayed for analysis as discussed above. For example, a larger data set may provide better localization at the cost of performance loss due to an increased amount of data.

The menu system 300 further includes visualization menu buttons 307. The visualization menu buttons 307 allow the user select additional display windows to control and/or display various plots and/or animations as discussed above. For example, the visualization menu buttons 307 may allow a user to select and/or control waveform display 251, complex distribution animation 253, waveform measurements 252, circularity plots 255, variance plots 256, and/or filter display 254. The visualization menu buttons 307 may also include a close button to allow a user to return to a previous control menu.

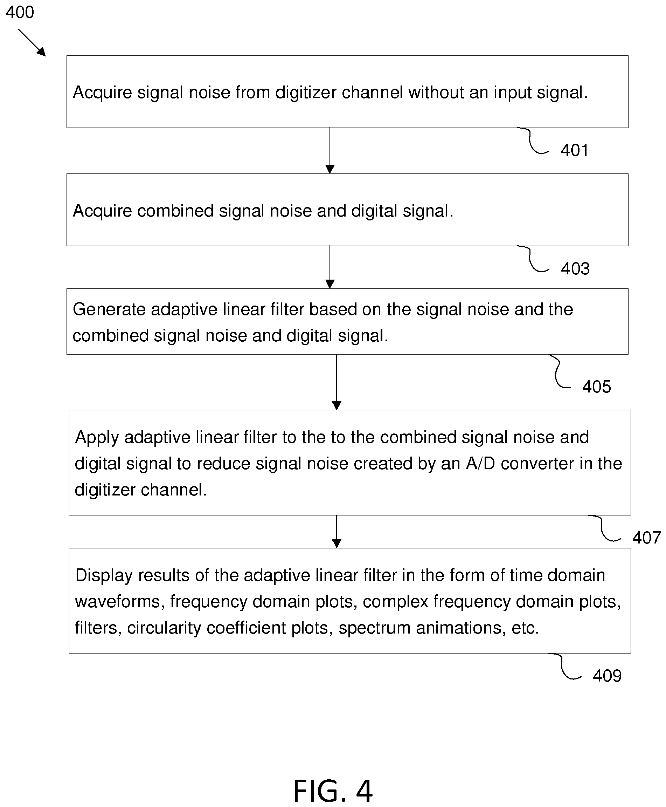

Fig. 4 is a flow chart of an example method 400 to apply an adaptive linear filter, such as adaptive linear filters 122 and/or 222, to a converted digital signal, such as digital signal 163. Method 400 may be applied by an oscilloscope such as oscilloscope 120 and/or 220. At block 401, channel noise, such as signal noise 228, is acquired from a digitizer channel, such as digitizer channel 225, without an input. As used in this context, acquire can be viewed as being synonymous with receive. For example, a user may be prompted to calibrate the oscilloscope by removing signal inputs and/or by sending a known waveform through the digitizer channel. The signal noise created by operation of the digitizer channel can then be measured by comparing the known waveform with that produced by the digitizer channel.

At block 403, a digital signal, such as digital signal 163, may be acquired/measured by the digitizer channel. As the digital signal is converted from an analog signal, such as analog signal 161, any noise from the digitizer channel can be imparted on the resulting digital signal during acquisition. At block 405, an adaptive linear filter is generated for the digital signal. The adaptive linear filter may be generated by converting both the signal noise acquired in block 401 and the combined signal noise and digital signal acquired in block 403 into the complex frequency domain. The digital signal and the signal noise can then be compared to generate an adaptive linear filter based on both the signal and the noise. The generation of the adaptive filter is discussed in more detail below. At block 407, the adaptive linear filter is applied to the combined signal noise and digital signal, as acquired at block 403. The adaptive linear filter may reduce and/or remove signal noise created by an A/D converter, such as A/D converter 125, in the digitizer channel.

At block 409, the results of the adaptive linear filter may be displayed, for example via a display such as display 129. The results of the adaptive linear filter may include time domain waveforms, such as the digital signal prior to conversion into the complex frequency domain. The results may also include frequency domain plots of the signal after conversion into a frequency domain, which may be accomplished by applying a transform on signal over a single time window. The displayed results may also include complex frequency domain plots which indicate frequency domain values of the signal over multiple specified time frames. Such data may be animated on the display to show changes to the data over multiple time frames. The displayed results may also include plots of filter responses, such as a spectrum response of the adaptive linear filter. The displayed results may also include various intermediate calculation data, such as animated plots of circularity coefficients and/or variance coefficients at different time frames and/or other spectrum animations.

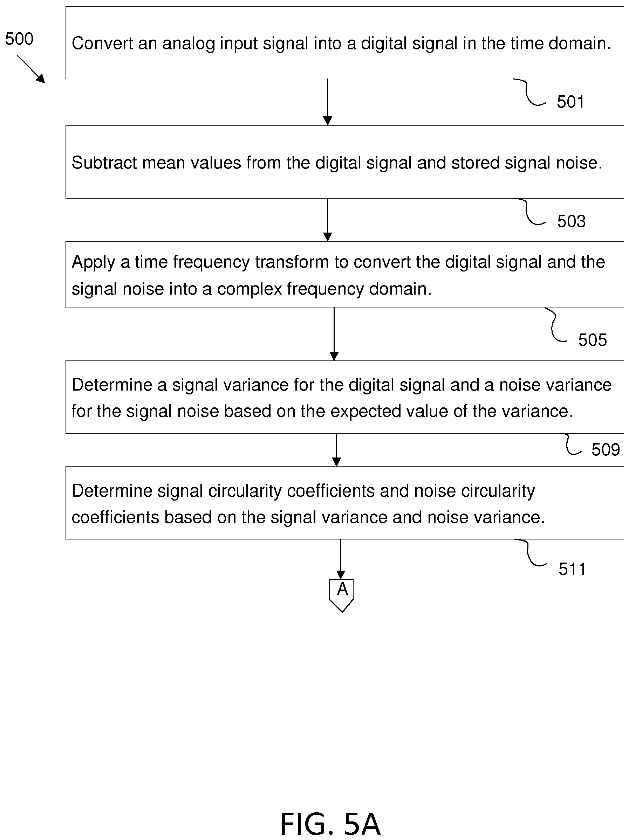

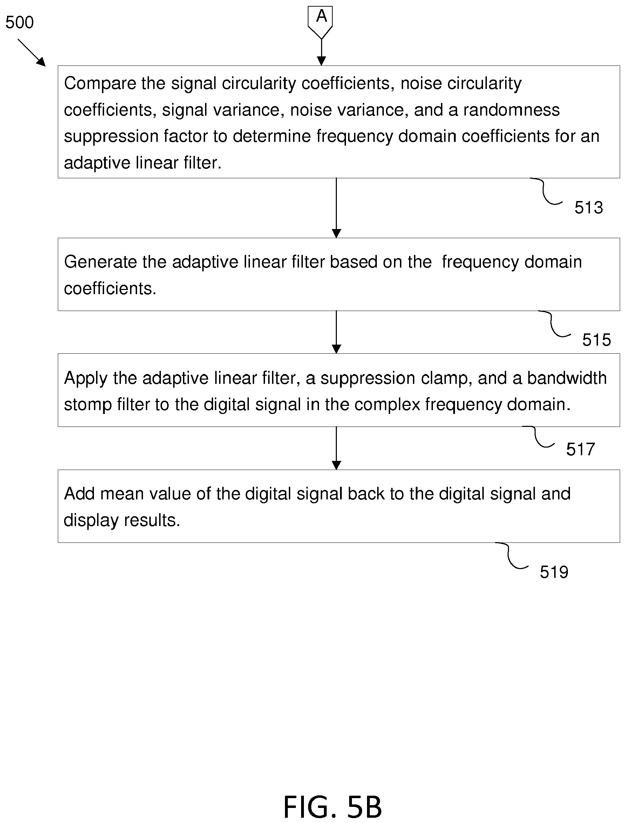

Figs. 5A-5B are a flow chart of an example method 500 of generating an adaptive linear filter, such as adaptive linear filters 122 and/or 222. Method 500 may operate on an oscilloscope 120 and/or 220. Further, method 500 may be a specific implementation of method 400, and is presented to further discuss the generation of the adaptive linear filter. For example, method 500 may be employed to implement blocks 405 and 407 of method 400. Method 500 is discussed, in part, in terms of equations. It should be noted that lower case letters are selected to denote time domain variables and upper case letters are selected to denote frequency domain variables. At block 501, an analog input signal, such as analog signal 161 and/or input signal 261, is converted into a digital signal, such as digital signal 163, in the time domain. Such conversion may be performed by an A/D converter in a digitizer channel, such as A/D converter 125 and digitizer channel 225, respectively. As discussed above, the digitizer may create noise in the digital signal, and hence the digital signal is a combined signal noise and digital signal as noted in block 403 of method 400. The conversion to the frequency domain, as discussed below, may involve determining frequency spectra as such spectra change over time. Accordingly, the digital signal may be considered in terms of frames of frequency data (e,g, STFT frames) over corresponding time ranges. Hence, the digital signal and corresponding noise may be expressed according to equation 1 in the time domain and equation 2 in the frequency domain:

$$y(n,m) = x(n,m) + v(n,m),$$

$$Y(n,m) = X(n,m) + V(n,m)$$

Equations 1-2

where ($n,m$) indicate values as a function of indexes n indicating a start time for each frame and m indicating a time range within each frame, $y(n,m)$ indicates the values of the acquired digital signal (e.g. digital signal 163) as a function of n and m in the time domain, $x(n,m)$ indicates the value of the input signal (e.g. analog signal 161 and/or input signal 261) as a function of n and m in the time domain, $v(n,m)$ indicates the value of the signal noise (e.g. signal noise 228), as a function of n and m in the time domain, $Y(n,m)$ indicates the values of the acquired digital signal as a function of n and m in the frequency domain, $X(n,m)$ indicates the value of the input signal as a function of n and m in the frequency domain, and $V(n,m)$ indicates the value of the signal noise as a function of n and m in the frequency domain.

At block 503, a mean value of the digital signal is subtracted from the digital signal and a mean value of the signal noise is subtracted from signal noise. As noted above, signal noise may be captured and stored during a calibration for this purpose (e.g. block 401 of method 400). Accordingly, a mean value of the digital signal and a mean value of the signal noise are removed prior to applying a time-frequency transform of block 505. Subtracting the mean values may be expressed as:

$$v(n,m) = v(n,m) - \mu_v,$$

$$y(n,m) = y(n,m) - \mu_y,$$

<div align="right">Equation 3-4</div>

where $\mu_v$ is the mean value of the noise and $\mu_y$ is the mean value of the digital signal. Mean values of the noise and digital signal may be determined according to:

$$\mu_y = \frac{1}{M} \cdot \sum_{m=1}^{M} y(m),$$

$$\mu_v = \frac{1}{M} \cdot \sum_{m=1}^{M} v(m),$$

<div align="right">Equation 5-6</div>

where M is the temporal length of the frame, $y(m)$ indicates the values of the acquired digital signal as a function of m, and $v(m)$ indicates the values of the signal noise as a function of m. As such, the signal and noise values, respectively, are then summed across the length of the frame divided by the length of the frame to obtain corresponding mean values. The mean values are removed prior to applying the time-frequency transform and then the mean value of the digital signal is added back to results from the adaptive linear filter at block 519.

At block 505, a time-frequency transform, such as SFTF, is applied to convert the digital signal and the signal noise into a complex frequency domain. Application of the transform may be expressed as:

$$Y(n,:) = FFT(y(n,:)),$$

$$V(n,:) = FFT(v(n,:)),$$

<div align="right">Equation 7-8</div>

where *FFT* indicates the transform employed, $y(n,:)$ indicates the values of the digital signal in the time domain over all indexes n, $Y(n,:)$ indicates the values of the resulting complex frequency domain signal over all indexes n, v(n,:) indicates the values of the signal noise in the time domain over all indexes n, and $V(n,:)$ indicates the values of the signal noise in the complex frequency domain over all indexes n.

At block 509, a signal variance for the digital signal and a noise variance for the signal noise are determined, respectively, in the complex frequency domain based on an expected value of the variance. The expected value of the variance may be determined according to:

$$E[|Y(n,m)|^2] = \frac{1}{N} \sum_{n}^{N} |Y(n,m)|^2,$$

$$E[|V(n,m)|^2] = \frac{1}{N} \sum_{n}^{N} |V(n,m)|^2,$$

<div align="right">Equation 9-10</div>

where $E[|Y(n,m)|^2]$ denotes the expected values of the variance for the digital signal, $E[|V(n,m)|^2]$ indicates the expected values of the variance for the signal noise, and N indicates a FFT frame range employed. As shown, the expected values of the variance are determined by squaring the absolute value of the digital signal and signal noise, respectively, summing the results across the indexes n for the N FFT frames. The expected values of the variance may also be determined

according to:

$$\Phi_v(m) = E[|V(n,m)|^2],$$

$$\Phi_y(m) = E[|Y(n,m)|^2],$$

$$\text{Equation 11-12}$$

where $\Phi_v(m)$ is the noise variance at an index m, $E[]$ are expected value of the variance, $V(n, m)$ is frequency domain signal noise in an n by m sized matrix of data stored for application of the time-frequency transform, $\Phi_y(m)$ is the signal variance at an index m, and $Y(n,m)$ is frequency domain digital signal data in an n by m sized matrix of data stored for application of the time-frequency transform.

At block 511, a signal circularity coefficient for the digital signal and a noise circularity coefficient for the signal noise are determined. The signal circularity coefficient and the noise circularity coefficient may be determined according to:

$$\gamma_y(m) = \frac{E[Y(n,m)^2]}{E[|Y(n,m)|^2]},$$

$$\gamma_v(m) = \frac{E[V(n,m)^2]}{E[|V(n,m)|^2]},$$

$$\text{Equation 13-14}$$

where $\gamma_y(m)$ is the signal circularity coefficient at an index m, $E[]$ are expected value of the variance, $Y(n,m)$ is frequency domain digital signal data in an n by m sized matrix of data stored for application of the time-frequency transform, $\gamma_v(m)$ is the noise circularity coefficient at an index m, and $V(n,m)$ is frequency domain signal noise in an n by m sized matrix of data stored for application of the time-frequency transform. It should be noted that the denominators of equations 13-14 are the signal and noise variances, which are real numbers and may not depend on phase. Meanwhile the numerators are squares of complex values that may depend on phase. Thus, the sum of the numerator can go to zero if the distribution is highly circular over the delay range indexed by n. Thus, $\gamma$ is referred to herein as the circularity coefficient because $\gamma$'s value at each frequency provides an indication of the degree of circularity of the signal/noise. The value of $\gamma$ has a range expressed by:

$$0 \leq \gamma(m) \leq 1$$

$$\text{Equation 15}$$

where $\gamma(m)$ is the circularity coefficient of a signal or a noise at an index m.

At block 513, frequency domain coefficients for the adaptive linear filter are generated by comparing the signal circularity coefficients and the noise circularity coefficients of block 511. The circularity coefficients are further compared to a signal variance and a noise variance a signal variance for the digital signal and a noise variance for the signal noise from block 509. In addition, a randomness suppression factor is included in the comparison. The randomness suppression factor assists in alleviating statistical errors caused by the noisy variations of the signal circularity coefficient and the noise circularity coefficient with the signal variance and the noise variance. Specifically, the randomness suppression factor (RSF1/RSF2) prevents divide by zero errors (e.g. not a number errors) and large spikes in values as the numerators and/or denominators approach zero during the comparison, for example due to errors in the expected values due to noise. Comparing the data obtained at block 513 results in determining frequency domain coefficients for the adaptive linear filter, for example by employing equations 16-17. The randomness suppression factor RSF2 may be 1000 times smaller than RFS1. An example value of RFS1 is 0.0001. Block 513 may generate frequency domain coefficients for the adaptive linear filter according to:

$$H(m) = 1 - \frac{1 - \gamma_v(m) \cdot \gamma_y^*(m) + RSF2}{1 - |\gamma_y(m)|^2 + RSF1} \cdot \frac{\Phi_v(m)}{\Phi_y(m)} ,$$

$$H'(m) = \frac{\gamma_y(m) - \gamma_v(m) + RSF2}{1 - |\gamma_y(m)|^2 + RSF1} \cdot \frac{\Phi_v(m)}{\Phi_y(m)} ,$$

Equations 16-17

where RSF1 and RSF2 the randomness suppression factor, * is a complex conjugate operator, $H(m)$ and $H'(m)$ are the frequency domain coefficients for the adaptive linear filter, and all other variables are as defined above.

At block 515, the adaptive linear filter is applied using the frequency domain coefficients of block 513 for application to the digital signal. The adaptive linear filter may be applied to the signal according to:

$$Yf(m) = H(m) \cdot Y(floor(\frac{N}{2}), m) + H'(m) \cdot Y^*(floor(\frac{N}{2}), m) ,$$

Equation 18

where $Yf(m)$ describes results of the adaptive linear filter as applied to the digital signal in the frequency domain as a function of an index m, $Y$ is the digital signal in the frequency domain, and $floor(\frac{N}{2}), m$ is a floor function to select an index at the middle frame in a matrix of spectral frames. It should be noted that the index for n may be selected at the center of the range of N. Thus statistics from frames on each side are used to compute the filter applied to the corresponding frame.

At block 517, the adaptive linear filter, according to equation 18, is applied to the digital signal to reduce, from the digital signal, signal noise created by the A/D converter. Further, a suppression clamp and a bandwidth stomp filter are applied to the results of the adaptive linear filter (e.g. the digital signal in the complex frequency domain.) As noted above, the suppression clamp may alleviate statistical errors at a Nyquist frequency of the A/D converter. The suppression clamp may be applied according to:

$$Yf(M/2) = 0 ,$$

Equation 19

where results of the adaptive linear filter $Yf(M)$ are set to zero at an index M at half of a sampling rate of the A/D converter. The bandwidth stomp filter may remove noise from the digital signal above a specified frequency. For example, a maximum frequency may be specified by a user or pre-programmed in memory to indicate the maximum allowable frequency of the input signal. Frequencies above the specified maximum frequency are noise and can be discarded. The bandwidth stomp filter may be applied according to:

$$Z(m) = Yf(m) \cdot Bw(m) ,$$

Equation 20

where $Z(m)$ is an output from the bandwidth stomp filter as a function of an index m, $Yf(m)$ describes results of the adaptive linear filter as applied to the digital signal in the frequency domain as a function of an index m, and $Bw(m)$ is the stomp filter coefficients as a function of frequency. The filtered waveform frame resulting from block 517 may be expressed in the time domain as:

$$z = ifft(Z),$$

$$\text{Equation 21}$$

where z is the filtered signal in the time domain and *ifft* (Z) is the inverse frequency transform of block 505 applied to the output of the filters of block 517.

At block 519, the mean value of the digital signal may be added back to the digital signal in the time domain. Such addition may be expressed as:

$$z(m) = z(m) + \mu_y,$$

$$\text{Equation 22}$$

where z(m) is an output of the filters of block 517 as a function of an index m and $\mu_y$ is the mean value of the digital signal as removed in block 503. It should be noted that rectangular windows may be employed for the FFT and the inverse FFT (IFFT). As such the ends of the z waveform record may include some transient ringing. As such, if a fifty percent overlap is assumed for the STFT frame positons for steps of k (e.g. time position), then only the middle fifty percent of the time record may be kept for the output waveform z (e.g. resulting the removal of the transient ringing). It should also be noted that method 500 filters a signal at a specified time position k. The value of k may be stepped to the next time position on the waveform and blocks of method 500 iteratively repeated to compute additional filter sets and outputs of the next set of points for the final output waveform z. The resulting waveform z may then be displayed to the user via a display, such as display 129, along with any desired intermediate steps, filters data, etc. It should also be noted that a fifty percent overlap may be assumed for steps of k, in which case only M/2 of the FFT frames are recomputed after each iteration. In such a case, an increment of k for a fifty percent overlap is expressed by:

$$k = k + floor\left(\frac{M}{2}\right),$$

where k is the time position and M is the temporal length of the frame.

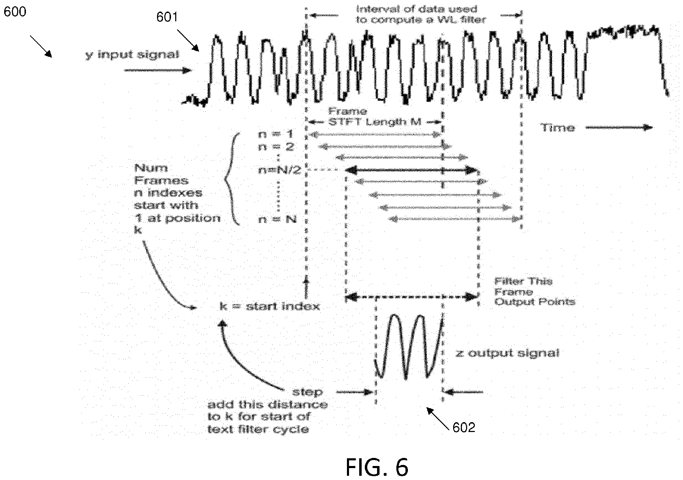

Fig. 6 illustrates an example mechanism 600 for converting an input signal 601 into a filtered complex frequency domain signal 602, for example by a linear adaptive filter 122 and/or 222 and/or according to method 400 and/or 500. An interval of data is employed to compute the adaptive linear filter (e.g. a WL filter) in the time domain. Accordingly, filter coefficients are created for each index k. Once the interval of data from k is determined, a FFT /SFTF frame of temporal length M (e.g. the horizontal axis) is computed (e.g. from m to M) along the amplitude axis (e.g. the vertical axis) from an index n to an index N. The output of the adaptive linear filter is then plotted as the time domain signal 602. The distance M is then added to k to move the computation to the next index k. The mechanism 600 may continue to the end of the input signal 601 to generate a corresponding set of complex frequency domain signals 602 at specified time frames.

Fig. 7 illustrates an example plot 700 of an unfiltered frequency domain signal 707 along with corresponding filters. For example, plot 700 may be generated by applying an a linear adaptive filter 122/222 and employing a filter display 254 function. The unfiltered frequency domain signal 707 is shown as a function of magnitude and frequency, depicted in black. The unfiltered frequency domain signal 707 may be generated by applying an FFT/SFTF to a digital signal, such as digital signal 163. A BW stomp filter 701 to be applied to the unfiltered frequency domain signal 707 is also depicted in teal in plot 700. Further, the frequency domain coefficients for the adaptive linear filter H(m) 703 and H'(m) 705, depicted in red and blue, respectively, to be applied to the unfiltered frequency domain signal 707 are also included in plot 700.

By depicting the unfiltered frequency domain signal 707 along with the frequency domain coefficients for the adaptive linear filter H(m) 703 and H'(m) 705 and BW stomp filter 701, a user may evaluate the effectiveness of the filters. Further, the plot 700 may provide additional signal analysis capability. The plot 700 may also assist the user to make decisions regarding appropriate setting for the menu parameters for number of frames and length of the adaptive linear filter. Plot 700 may also be employed to assist the user in deciding the cutoff frequency to be employed for the BW stomp filter.

It should be noted that the unfiltered frequency domain signal 707 includes multiple frames of Y(n,m) overlaid. The example shown was generated based on a signal y modulated as a pseudorandom binary sequence (PRBS) signal and acquired on an oscilloscope digitizing system. For the signal 707 shown, H(m) 703 has a gain of one wherever the signal to noise ratio is very high at the lower frequencies below seven gigahertz (GHz). The signal is stronger at the third and fifth harmonics where the adaptive linear filter has peaks. In between the main signal harmonics the adaptive linear filter has less gain, which attenuates some noise spectrum.

The BW stomp filter 701 can increase the SNR ratio by about four decibels depending on where the cutoff frequency is placed. This noise reduction is accomplished without distorting the signal because the BW stomp filter 701 rejects only high frequency out of band noise. Further, the adaptive linear filter can reduce in band noise (e.g. via H(m) 703 and H'(m) 705) where the BW stomp filter 701 does not. Therefore, the BW stomp filter 701 and the adaptive linear filter, when both applied, can reduce noise more than if only the BW stomp filter 701 is applied.

As such, a plot such as plot 700 may be employed when an adaptive linear filter is applied to a complex frequency domain signal to remove signal noise created by an A/D converter from the complex frequency domain signal. The plot 700 may display the complex frequency domain signal (e.g. unfiltered signal 707) and the adaptive filter (e.g. H(m) 703 and H'(m) 705) on a common display as a function of magnitude and frequency. Further, a bandwidth stomp filter 701 may be applied to the complex frequency domain signal. The bandwidth stomp filter 701 may remove noise from the complex frequency domain signal above a specified frequency. The plot 700 may display the bandwidth stomp filter 701 on the common display with the complex frequency domain signal (e.g. unfiltered signal 707) and the adaptive filter (e.g. H(m) 703 and H'(m) 705) as a function of magnitude and frequency.

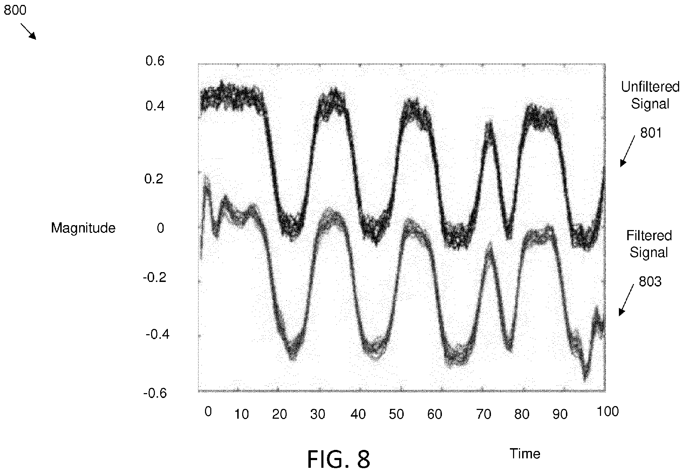

Fig. 8 illustrates an example plot 800 of a signal before and after noise reduction by an adaptive linear filter, such as an adaptive linear filter 122 and/or 222. Plot 800 includes an unfiltered signal 801 and a filtered signal 803 in terms of volts over time after application of an FFT/SFTF, the adaptive linear filter, and a corresponding IFFT. The filtered signal 803 includes around five decibels of total noise reduction in comparison to unfiltered signal 801. Plot 800 includes one frame of length M. It should be noted that ringing transients are included at each end of the record due to the rectangular window function. However, only the middle M/2 points of the data are retained as the output from the filter to remove such ringing.

Fig. 9 illustrates an example complex distribution animation 900, for example as generated by a complex distribution animation 253 of an oscilloscope 120 and/or 220. Complex distribution animation 900 includes color graphs animated as a function of delay of an FFT/SFTF frame on a time record of a digital signal. Animation 900 includes a time domain view 901 of a frame of an ideal input waveform, a waveform with inter-symbol interference (ISI), and input waveform including ISI and channel noise, depicted in red, blue, and green, respectively. It should be noted that the ideal input waveform and the waveform with ISI are included for purposes of clarity, and only the waveform with both ISI and noise are shown on a functioning oscilloscope. The arrows indicate the direction of movement of the signal(s) in the display graph of the time domain view 901 and in a spectrum 903.

The animation 900 also includes the spectrum 903 of the frame data. Each dot in the spectrum 903 indicates one of the frequencies in the spectrum. The horizontal axis indicates real values and the vertical axis indicates imaginary values. The complex conjugate half of the FFT data is also shown. The cluster in the middle shows the circular distribution of the noise, as open pick dots, and the several data points outside the noise cluster are the coherent harmonics in the signal, depicted as solid colored dots. While the example complex distribution animation 900 shows a single frame, it should be noted that an animation on an oscilloscope would show multiple frames in sequence with varying delays. The animation would show all frames in the waveform and, therefore become a valuable analysis tool. The bottom graph 900 shows the waveform with noise. The dotted lines are the frame end marker positions, which depict current frame position for the upper two graphs 901 and 903.

The harmonics in the complex domain spectrum 900 can be colored with accent colors to make them easy to identify, for example to denote such values when their trajectory moves them through the noise cluster. This allows them to be easily tracked as the animation plays. It should be noted that the first harmonic in the spectrum 903 makes a crossing of the imaginary axis each time a rising edge crosses the center position of the frame window. The harmonic crosses the negative imaginary axis each time a negative falling edge crosses the center position of the frame. Therefore, frame size and step increments for the n index can be setup by taking into account the amount of rotaion desired for the distributions to rotate far enough such that a circular distribution vs non-circular distribtuions can be computed adequately.

Animation 900 also includes a time domain view of the complete waveform 905 for reference. The time domain view of the complete waveform 905 depicts an ideal input waveform in green, a waveform with ISI in blue, and the input waveform including ISI and channel noise in red.

As such, by applying an animation such as animation 900, an oscilloscope may convert, by an A/D converter, an analog input signal into a digital signal in a time domain. Then a time-frequency transform may be applied to convert the digital signal into a complex frequency domain signal. Further, a display may be employed to display a spectrum 903 from frames of the complex frequency domain signal. The spectrum 903 may be displayed on a real axis and an imaginary axis. The spectrum 903 may further display a distribution of complex frequency domain signal power and complex frequency domain noise power as a function of digital signal phase and magnitude. Further, the spectrum 903 may be displayed to depict circularity characteristics of the complex frequency domain signal and complex frequency domain noise by time position of the digital signal in a time domain.

Fig. 10 illustrates an example plot 1000 of circularity coefficients plotted as a function of frequency. Example plot 1000 indicates circularity coefficients for the signal 1001 and circularity coefficients for the noise 1003. Plot 1000 shows the circularity coefficients depicted by persistence. Plot 1000 is an example plot that may be generated by a circularity plots 255 function. As shown, plot 1000 may allow a user to evaluate the circularity of the noise and the signal, and hence the effectiveness of the corresponding adaptive linear filter.

Fig. 11 illustrates an example plot 1100 of circularity coefficients plotted for an FFT frame on a real axis (horizontal) and an imaginary axis (vertical). Plot 1100 is another example of a format that may be employed by a circularity plot 255 function. As with spectrum 903, each dot on the plot 1100 is for a different frequency for all points above zero on the imaginary axis. All points below zero on the imaginary axis are the complex conjugates of the points above the real axis. As such, plots 1000 and 1100 may be employed when an adaptive linear filter is applied to a complex frequency domain signal to remove signal noise created by an A/D converter from the complex frequency domain signal. The plots 1000 and 1100 display circularity coefficients of the adaptive linear filter.

Fig. 12 illustrates an example plot 1200 of variance coefficients plotted as a function of frequency. Plot 1200 is an example plot that may be generated by a variance plots 256 function. As shown, plot 1200 may allow a user to determine frequency locations where signal variance extremes occur and adjust settings accordingly, for example by modifying filter settings, etc.

Examples of the invention may operate on a particularly created hardware, on firmware, digital signal processors, or on a specially programmed general purpose computer including a processor operating according to programmed instructions. The terms "controller" or "processor" as used herein are intended to include microprocessors, microcomputers, ASICs, and dedicated hardware controllers. One or more aspects of the invention may be embodied in computer-usable data and computer-executable instructions, such as in one or more program modules, executed by one or more computers (including monitoring modules), or other devices. Generally, program modules include routines, programs, objects, components, data structures, etc. that perform particular tasks or implement particular abstract data types when executed by a processor in a computer or other device. The computer executable instructions may be stored on a computer readable storage medium such as a hard disk, optical disk, removable storage media, solid state memory, RAM, etc. As will be appreciated by one of skill in the art, the functionality of the program modules may be combined or distributed as desired in various examples. In addition, the functionality may be embodied in whole or in part in firmware or hardware equivalents such as integrated circuits, field programmable gate arrays (FPGA), and the like. Particular data structures may be used to more effectively implement one or more aspects of the invention, and such data structures are contemplated within the scope of computer executable instructions and computer-usable data described herein.

Aspects of the present disclosure operate with various modifications and in alternative forms. Specific aspects have been shown by way of example in the drawings and are described in detail herein below. However, it should be noted that the examples disclosed herein are presented for the purposes of clarity of discussion and are not intended to limit the scope of the general concepts disclosed to the specific examples described herein unless expressly limited. As such, the present disclosure is intended to cover all modifications, equivalents, and alternatives of the described aspects in light of the attached drawings and claims.

References in the specification to embodiment, aspect, example, etc., indicate that the described item may include a particular feature, structure, or characteristic. However, every disclosed aspect may or may not necessarily include that particular feature, structure, or characteristic. Moreover, such phrases are not necessarily referring to the same aspect unless specifically noted. Further, when a particular feature, structure, or characteristic is described in connection with a particular aspect, such feature, structure, or characteristic can be employed in connection with another disclosed aspect whether or not such feature is explicitly described in conjunction with such other disclosed aspect.

The disclosed aspects may be implemented, in some cases, in hardware, firmware, software, or any combination thereof. The disclosed aspects may also be implemented as instructions carried by or stored on one or more or computer-readable media, which may be read and executed by one or more processors. Such instructions may be referred to as a computer program product. Computer-readable media, as discussed herein, means any media that can be accessed by a computing device. By way of example, and not limitation, computer-readable media may comprise computer storage media and communication media.

Computer storage media means any medium that can be used to store computer-readable information. By way of example, and not limitation, computer storage media may include Random Access Memory (RAM), Read Only Memory (ROM), Electrically Erasable Programmable Read-Only Memory (EEPROM), flash memory or other memory technology, Compact Disc Read Only Memory (CD-ROM), Digital Video Disc (DVD), or other optical disk storage, magnetic cassettes, magnetic tape, magnetic disk storage or other magnetic storage devices, and any other volatile or nonvolatile, removable or non-removable media implemented in any technology. Computer storage media excludes signals per se and transitory forms of signal transmission.

Communication media means any media that can be used for the communication of computer-readable information. By way of example, and not limitation, communication media may include coaxial cables, fiber-optic cables, air, or any other media suitable for the communication of electrical, optical, Radio Frequency (RF), infrared, acoustic or other types of signals.

**EXAMPLES**

Illustrative examples of the technologies disclosed herein are provided below. An embodiment of the technologies may include any one or more, and any combination of, the examples described below.

Example 1 includes a test and measurement system comprising: an analog to digital (A/D) converter to produce a digital signal from an analog signal, the digital signal including channel noise introduced by the A/D converter; a waveform memory, coupled with the A/D converter, to store the digital signal; and a processor, coupled with the waveform memory, to: convert the digital signal into a complex frequency domain by applying a time-frequency transform to the digital signal, determine a signal circularity coefficient for the digital signal and a noise circularity coefficient for the channel noise, generate frequency domain coefficients for an adaptive linear filter through a comparison of the signal circularity coefficient and the noise circularity coefficient, and apply the adaptive linear filter to the digital signal to reduce the channel noise from the digital signal.

Example 2 includes the test and measurement system of Example 1, wherein the comparison of the signal circularity coefficient and the noise circularity coefficient includes an application of a randomness suppression factor to reduce statistical errors caused by the comparison.

Example 3 includes the test and measurement system of Examples 1-2, wherein the processor is further to apply a suppression clamp to results from the adaptive linear filter, the suppression clamp to reduce statistical errors at a Nyquist frequency of the A/D converter.

Example 4 includes the test and measurement system of Examples 1-3, wherein the processor is further to apply a bandwidth stomp filter to results from the adaptive linear filter, the bandwidth stomp filter to remove channel noise from the digital signal above a specified frequency.

Example 5 includes the test and measurement system of Examples 1-4, wherein the adaptive linear filter to reduce the channel noise is further applied by determining a signal variance for the digital signal and a noise variance for the channel noise.

Example 6 includes the test and measurement system of Example 5, wherein the frequency domain coefficients for the adaptive linear filter are further generated by comparing the signal circularity coefficient and the noise circularity coefficient to the signal variance and the noise variance.

Example 7 includes the test and measurement system of Examples 1-6, wherein a mean value of the digital signal and a mean value of the channel noise are removed prior to applying the time-frequency transform, and the mean value of the digital signal is added back to results from the adaptive linear filter.

Example 8 includes a computer readable storage medium for storing a computer program product comprising instructions that, when executed by a processor of a test and measurement system, causing the test and measurement system to: produce, by an analog to digital (A/D) converter, a digital signal from an analog signal, the digital signal including channel noise introduced by the A/D converter; convert the digital signal into a complex frequency domain by applying a time-frequency transform to the digital signal; determine a signal circularity coefficient for the digital signal and a noise circularity coefficient for the channel noise; generate frequency domain coefficients for an adaptive linear filter through comparison of the signal circularity coefficient and the noise circularity coefficient through application of a randomness suppression factor for reduction of statistical errors caused by the comparison of the signal circularity coefficient and the noise circularity coefficient; and apply the adaptive linear filter to the digital signal to reduce the channel noise from the digital signal.

Example 9 includes the computer readable storage medium of Example 8, wherein the adaptive linear filter for reducing the channel noise is further applied by determining a signal variance for the digital signal and a noise variance for the channel noise.

Example 10 includes the computer readable storage medium of Example 9, wherein the signal variance for the digital signal and the noise variance for the channel noise are determined according to:

$$\Phi_v(m) = E[|V(n,m)|^2] \text{ and } \Phi_y(m) = E[|Y(n,m)|^2],$$

where $\Phi_v(m)$ is the noise variance at an index m, $E[\,]$ are expected values of the variance, $V(n,m)$ is frequency domain channel noise in an n by m sized matrix of data stored for application of the time-frequency transform, $\Phi_y(m)$

is the signal variance at an index m, and $Y(n,m)$ is frequency domain digital signal data in an n by m sized matrix of data stored for application of the time-frequency transform.

Example 11 includes the computer readable storage medium of Examples 8-10, wherein the signal circularity coefficient and the noise circularity coefficient are determined according to:

$$\gamma_y(m) = \frac{E[Y(n,m)^2]}{E[|Y(n,m)|^2]} \quad \text{and} \quad \gamma_v(m) = \frac{E[V(n,m)^2]}{E[|V(n,m)|^2]},$$

where $\gamma_y(m)$ is the signal circularity coefficient at an index m, E [] are expected values of the variance, $Y(n,m)$ is frequency domain digital signal data in an n by m sized matrix of data stored for application of the time-frequency transform, $\gamma_v(m)$ is the noise circularity coefficient at an index m, and $V(n,m)$ is frequency domain channel noise in an n by m sized matrix of data stored for application of the time-frequency transform.

Example 12 includes the computer readable storage medium of Examples 8-11, wherein the frequency domain coefficients for the adaptive linear filter generated according to:

$$H(m) = 1 - \frac{1 - \gamma_v(m) \cdot \gamma_y^*(m) + RSF2}{1 - |\gamma_y(m)|^2 + RSF1} \cdot \frac{\Phi_v(m)}{\Phi_y(m)} \quad \text{and} \quad H'(m) = \frac{\gamma_y(m) - \gamma_v(m) + RSF2}{1 - |\gamma_y(m)|^2 + RSF1} \cdot \frac{\Phi_v(m)}{\Phi_y(m)},$$

where RSF1 and RSF2 are the randomness suppression factor, * is a complex conjugate operator, and $H(m)$ and $H'(m)$ are the frequency domain coefficients for the adaptive linear filter.

Example 13 includes the computer readable storage medium of Examples 8-12, wherein the adaptive linear filter is applied according to:

$$Yf(m) = H(m) \cdot Y(floor(\frac{N}{2}), m) + H'(m) \cdot Y^*(floor(\frac{N}{2}), m),$$

where $Yf(m)$ describes results of the adaptive linear filter as applied to the digital signal in the frequency domain as a function of an index m, $Y$ is the digital signal in the frequency domain, and $floor(\frac{N}{2}), m$ is a floor function to select an index at the middle frame in a matrix of spectral frames.

Example 14 includes the computer readable storage medium of Examples 8-13, wherein the instructions further cause the test and measurement system to apply a suppression clamp to results from the adaptive linear filter, the suppression clamp to reduce statistical errors at a Nyquist frequency of the A/D converter, the suppression clamp applied according to:

$$Yf(M/2) = 0,$$

where results of the adaptive linear filter are set to zero at an index M at half of a sampling rate of the A/D converter.

Example 15 includes the computer readable storage medium of Examples 8-14, wherein the instructions further cause the test and measurement system to apply a bandwidth stomp filter to results from the adaptive linear filter, the bandwidth stomp filter for removing channel noise from the digital signal above a specified frequency, the bandwidth stomp filter applied according to:

$$Z(m) = Yf(m) \cdot Bw(m),$$

where $Z(m)$ is an output from the bandwidth stomp filter, $Yf(m)$ describes results of the adaptive linear filter as applied to the digital signal in the frequency domain as a function of an index m, and $Bw(m)$ is the bandwidth stomp filter coefficients as a function of frequency.

Example 16 includes a method comprising: converting, by an analog to digital (A/D) converter, an analog input signal into a digital signal in a time domain; applying a time-frequency transform to convert the digital signal into a complex frequency domain signal; and displaying a spectrum from frames of the complex frequency domain signal, the spectrum displayed on a real axis and an imaginary axis, the spectrum further displaying a distribution of complex frequency domain signal power and complex frequency domain noise power as a function of digital signal phase and magnitude.

Example 17 includes the method of Example 16, wherein the spectrum is displayed to depict circularity characteristics of the complex frequency domain signal and complex frequency domain noise by time position of the digital signal in a time domain.

Example 18 includes the method of Examples 16-17, further comprising: applying an adaptive linear filter to the complex frequency domain signal to remove channel noise created by the A/D converter from the complex frequency domain signal; and displaying the complex frequency domain signal and the adaptive filter on a common display as a function of magnitude and frequency.

Example 19 includes the method of Examples 16-18, further comprising: applying a bandwidth stomp filter to the complex frequency domain signal, the bandwidth stomp filter for removing channel noise from the complex frequency domain signal above a specified frequency; and displaying the bandwidth stomp filter on the common display with the complex frequency domain signal and the adaptive filter as a function of magnitude and frequency.

Example 20 includes the method of Examples 16-19, further comprising: applying an adaptive linear filter to the complex frequency domain signal to remove channel noise created by the A/D converter from the complex frequency domain signal; and displaying circularity coefficients of the adaptive linear filter.

Example 21 includes a test and measurement system configured to perform the method of any of Examples 16-20.

Example 22 includes one or more computer-readable media having instructions stored thereon which, when executed by a processor of a test and measurement system, cause the test and measurement system to perform the method of any of Examples 16-20.

Example 23 includes a method comprising the steps performed by the test and measurement system of any of Examples 1-7.

The previously described versions of the disclosed subject matter have many advantages that were either described or would be apparent to a person of ordinary skill. Even so, all of these advantages or features are not required in all versions of the disclosed apparatus, systems, or methods.

Additionally, this written description makes reference to particular features. It is to be understood that the disclosure in this specification includes all possible combinations of those particular features. Where a particular feature is disclosed in the context of a particular aspect or example, that feature can also be used, to the extent possible, in the context of other aspects and examples.

Also, when reference is made in this application to a method having two or more defined steps or operations, the defined steps or operations can be carried out in any order or simultaneously, unless the context excludes those possibilities.

Although specific examples of the invention have been illustrated and described for purposes of illustration, it will be understood that various modifications may be made without departing from the scope of the invention. Accordingly, the invention should not be limited except as by the appended claims.

**Claims**

1. A test and measurement system comprising:

an analog to digital, A/D, converter to produce a digital signal from an analog signal, the digital signal including channel noise introduced by the A/D converter;
a waveform memory, coupled with the A/D converter, to store the digital signal; and
a processor, coupled with the waveform memory, to:

convert the digital signal into a complex frequency domain by applying a time-frequency transform to the digital signal,
determine a signal circularity coefficient for the digital signal and a noise circularity coefficient for the channel noise,
generate frequency domain coefficients for an adaptive linear filter through a comparison of the signal circularity coefficient and the noise circularity coefficient, and
apply the adaptive linear filter to the digital signal to reduce the channel noise from the digital signal.

2. The test and measurement system of claim 1, wherein the comparison of the signal circularity coefficient and the noise circularity coefficient includes an application of a randomness suppression factor to reduce statistical errors caused by the comparison.

3. The test and measurement system of claim 1 or 2, wherein the processor is further to:

apply a suppression clamp to results from the adaptive linear filter, the suppression clamp to reduce statistical errors at a Nyquist frequency of the A/D converter; and/or
apply a bandwidth stomp filter to results from the adaptive linear filter, the bandwidth stomp filter to remove channel noise from the digital signal above a specified frequency.

4. The test and measurement system of any of claims 1 to 3, wherein the adaptive linear filter to reduce the channel noise is further applied by determining a signal variance for the digital signal and a noise variance for the channel noise.

5. The test and measurement system of any of claims 1 to 4, wherein the frequency domain coefficients for the adaptive linear filter are further generated by comparing the signal circularity coefficient and the noise circularity coefficient to the signal variance and the noise variance.

6. The test and measurement system of any of claims 1 to 5, wherein a mean value of the digital signal and a mean value of the channel noise are removed prior to applying the time-frequency transform, and the mean value of the digital signal is added back to results from the adaptive linear filter.

7. A computer readable storage medium having instructions stored thereon that, when executed by a processor of a test and measurement system, cause the test and measurement system to:

convert a digital signal into a complex frequency domain by applying a time-frequency transform to the digital signal, the digital signal including channel noise introduced by an analog to digital (A/D) converter that produced the digital signal;
determine a signal circularity coefficient for the digital signal and a noise circularity coefficient for the channel noise;
generate frequency domain coefficients for an adaptive linear filter through comparison of the signal circularity coefficient and the noise circularity coefficient through application of a randomness suppression factor for reduction of statistical errors caused by the comparison of the signal circularity coefficient and the noise circularity coefficient; and
apply the adaptive linear filter to the digital signal to reduce the channel noise from the digital signal.

8. The computer readable storage medium of claim 7, wherein the adaptive linear filter for reducing the channel noise is further applied by determining a signal variance for the digital signal and a noise variance for the channel noise.

9. The computer readable storage medium of claim 8, wherein the signal variance for the digital signal and the noise variance for the channel noise are determined according to:

$$\Phi_v(m) = E[|V(n,m)|^2] \text{ and } \Phi_y(m) = E[|Y(n,m)|^2],$$

where $\Phi_v(m)$ is the noise variance at an index m, $E[]$ are expected values of the variance, $V(n, m)$ is frequency domain channel noise in an n by m sized matrix of data stored for application of the time-frequency transform, $\Phi_y(m)$ is the signal variance at an index m, and $Y(n,m)$ is frequency domain digital signal data in an n by m sized matrix of data stored for application of the time-frequency transform.

10. The computer readable storage medium of any of claims 7 to 9, wherein the signal circularity coefficient and the noise circularity coefficient are determined according to:

$$\gamma_y(m) = \frac{E[Y(n,m)^2]}{E[|Y(n,m)|^2]} \text{ and } \gamma_v(m) = \frac{E[V(n,m)^2]}{E[|V(n,m)|^2]},$$

where $\gamma_y(m)$ is the signal circularity coefficient at an index m, $E$ [] are expected values of the variance, $Y(n,m)$ is frequency domain digital signal data in an n by m sized matrix of data stored for application of the time-frequency transform, $\gamma_v(m)$ is the noise circularity coefficient at an index m, and $V(n,m)$ is frequency domain channel noise in an n by m sized matrix of data stored for application of the time-frequency transform.

11. The computer readable storage medium of any of claims 7 to 10, wherein the frequency domain coefficients for the adaptive linear filter generated according to:

$$H(m) = 1 - \frac{1 - \gamma_v(m) \cdot \gamma_y^*(m) + RSF2}{1 - |\gamma_y(m)|^2 + RSF1} \cdot \frac{\Phi_v(m)}{\Phi_y(m)} \text{ and } H'(m) = \frac{\gamma_y(m) - \gamma_v(m) + RSF2}{1 - |\gamma_y(m)|^2 + RSF1} \cdot \frac{\Phi_v(m)}{\Phi_y(m)},$$

where RSF1 and RSF2 are the randomness suppression factor, * is a complex conjugate operator, and $H(m)$ and $H'(m)$ are the frequency domain coefficients for the adaptive linear filter; and/or
wherein the adaptive linear filter is applied according to:

$$Yf(m) = H(m) \cdot Y(floor(\frac{N}{2}), m) + H'(m) \cdot Y^*(floor(\frac{N}{2}), m),$$

where $Yf(m)$ describes results of the adaptive linear filter as applied to the digital signal in the frequency domain as a function of an index m, $Y$ is the digital signal in the frequency domain, and $floor(\frac{N}{2}), m$ is a floor function to select an index at the middle frame in a matrix of spectral frames.

12. The computer readable storage medium of any of claims 7 to 11, wherein the instructions further cause the test and measurement system to apply:

a suppression clamp to results from the adaptive linear filter, the suppression clamp to reduce statistical errors at a Nyquist frequency of the A/D converter, the suppression clamp applied according to:

$$Yf(M/2) = 0,$$

where results of the adaptive linear filter are set to zero at an index M at half of a sampling rate of the A/D converter; and/or
a bandwidth stomp filter to results from the adaptive linear filter, the bandwidth stomp filter for removing channel noise from the digital signal above a specified frequency, the bandwidth stomp filter applied according to:

$$Z(m) = Yf(m) \cdot Bw(m),$$

where $Z(m)$ is an output from the bandwidth stomp filter, $Yf(m)$ describes results of the adaptive linear filter as applied to the digital signal in the frequency domain as a function of an index m, and $Bw(m)$ is the bandwidth stomp filter coefficients as a function of frequency.

13. A method comprising:

converting, by an analog to digital (A/D) converter, an analog input signal into a digital signal in a time domain; applying a time-frequency transform to convert the digital signal into a complex frequency domain signal; and displaying a spectrum from frames of the complex frequency domain signal, the spectrum displayed on a real axis and an imaginary axis, the spectrum further displaying a distribution of complex frequency domain signal power and complex frequency domain noise power as a function of digital signal phase and magnitude.

14. The method of claim 13, wherein the spectrum is displayed to depict circularity characteristics of the complex frequency domain signal and complex frequency domain noise by time position of the digital signal in a time domain; and/or
further comprising:

applying an adaptive linear filter to the complex frequency domain signal to remove channel noise created by the A/D converter from the complex frequency domain signal; and
displaying the complex frequency domain signal and the adaptive filter on a common display as a function of magnitude and frequency; and/or

further comprising:

applying an adaptive linear filter to the complex frequency domain signal to remove channel noise created by the A/D converter from the complex frequency domain signal; and
displaying circularity coefficients of the adaptive linear filter.

15. The method of claim 13 or 14, further comprising:

applying a bandwidth stomp filter to the complex frequency domain signal, the bandwidth stomp filter for removing channel noise from the complex frequency domain signal above a specified frequency; and
displaying the bandwidth stomp filter on the common display with the complex frequency domain signal and the adaptive filter as a function of magnitude and frequency.

100

120

Oscilloscope

Display                                    129

110

DUT

Input
Port

A/D

Waveform
Memory

Processor          121

122

Adaptive
Linear Filter

Analog Signal

161

127          125

Digital Signal

163

123

165

Complex Frequency
Domain Signal

Analog
Domain

131

Digital
Domain

132

Complex
Frequency
Domain

133

FIG. 1

200

220     Oscilloscope     252

225

Input Signal
261

Digitizer Channel

228

y

Adaptive
Linear Filter
222

Control
Menu
224

251

Waveform
Display

Waveform
Measurements

Complex
Distribution
Animation
253

Circularity
Plots
255     254

Filter
Display

Variance
Plots
256

FIG. 2

300

Application Control Menu System

301 →

Noise Reduction
○ On
○ Off

Acquire Noise

302 →
Cal ►

BW Limit Filter
○ Auto
○ Custom

303 →

304 →
Design ►

Operations Mode  305
○ Adaptive
○ Train & Hold

WL Filter Parameters  306
○ Auto
○ Custom

Num.      Filter
Frames    Length

Distribution
Animation  307
Play ►

Visualization
Plots ►

Close

FIG. 3

400

Acquire signal noise from digitizer channel without an input signal.

401

Acquire combined signal noise and digital signal.

403

Generate adaptive linear filter based on the signal noise and the combined signal noise and digital signal.

405

Apply adaptive linear filter to the to the combined signal noise and digital signal to reduce signal noise created by an A/D converter in the digitizer channel.

407

Display results of the adaptive linear filter in the form of time domain waveforms, frequency domain plots, complex frequency domain plots, filters, circularity coefficient plots, spectrum animations, etc.

409

# FIG. 4

500

Convert an analog input signal into a digital signal in the time domain.

501

Subtract mean values from the digital signal and stored signal noise.

503

Apply a time frequency transform to convert the digital signal and the signal noise into a complex frequency domain.

505

Determine a signal variance for the digital signal and a noise variance for the signal noise based on the expected value of the variance.

509

Determine signal circularity coefficients and noise circularity coefficients based on the signal variance and noise variance.

511

A

# FIG. 5A

500

A

Compare the signal circularity coefficients, noise circularity coefficients, signal variance, noise variance, and a randomness suppression factor to determine frequency domain coefficients for an adaptive linear filter.

513

Generate the adaptive linear filter based on the frequency domain coefficients.

515

Apply the adaptive linear filter, a suppression clamp, and a bandwidth stomp filter to the digital signal in the complex frequency domain.

517

Add mean value of the digital signal back to the digital signal and display results.

519

# FIG. 5B

FIG. 6

FIG. 7

FIG. 8

FIG. 9

FIG. 10

FIG. 11

FIG. 12

Europäisches
Patentamt

European
Patent Office

Office européen
des brevets

# EUROPEAN SEARCH REPORT

Application Number

EP 17 16 5599

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2014/241539 A1 (BAL ANKUR [IN] ET AL) 28 August 2014 (2014-08-28) * paragraphs [0002], [0004], [0006], [0020] - [0023], [0027] - [0035]; figures 1,6 * | 1-15 | INV. G01R13/00 G01R13/22 H03H21/00 H03M1/12 |
| A | DE 37 00 368 C1 (ROHDE & SCHWARZ) 1 June 1988 (1988-06-01) * abstract; claim 1; figure 1 * * column 2, line 33 - column 2, line 64 * | 1-15 | |
| A | ADALI TULAY ET AL: "Optimization and Estimation of Complex-Valued Signals: Theory and applications in filtering and blind source separation", IEEE SIGNAL PROCESSING MAGAZINE, IEEE SERVICE CENTER, PISCATAWAY, NJ, US, vol. 31, no. 5, 30 September 2014 (2014-09-30), pages 112-128, XP011556974, ISSN: 1053-5888, DOI: 10.1109/MSP.2013.2287951 [retrieved on 2014-08-18] * page 117, paragraph STATISTICS - page 118, paragraph CIRCULARITY COEFFICIENTS AND ENTROPY; figure 1 * * page 121, paragraph APPLICATIONS - page 122, paragraph EXAMPLE * | 1-15 | TECHNICAL FIELDS SEARCHED (IPC) G01R H03H H03M |

The present search report has been drawn up for all claims

| Place of search | Date of completion of the search | Examiner |
|---|---|---|
| Munich | 1 September 2017 | Maric, Viktor |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 17 16 5599

This annex lists the patent family members relating to the patent documents cited in the above-mentioned European search report.
The members are as contained in the European Patent Office EDP file on
The European Patent Office is in no way liable for these particulars which are merely given for the purpose of information.

01-09-2017

| Patent document cited in search report | Publication date | Patent family member(s) | Publication date |
|---|---|---|---|
| US 2014241539 A1 | 28-08-2014 | US 2011142254 A1<br>US 2014241539 A1<br>US 2017249931 A1 | 16-06-2011<br>28-08-2014<br>31-08-2017 |
| DE 3700368 C1 | 01-06-1988 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 62319916 A

**Non-patent literature cited in the description**

- **JOHN J. PICKERD et al.** *Widely Linear Noise Reduction And Analysis System For A Test And Measurement Instrument*